(19) Europäisches Patentamt

European Patent Office

Office européen des brevets

(11) **EP 0 995 266 B1**

(12) **EUROPEAN PATENT SPECIFICATION**

(45) Date of publication and mention
of the grant of the patent:
**23.01.2002 Bulletin 2002/04**

(21) Application number: **98932310.0**

(22) Date of filing: **29.06.1998**

(51) Int Cl.⁷: **H03H 11/40**, H02M 1/12

(86) International application number:
**PCT/GB98/01897**

(87) International publication number:
**WO 99/01932 (14.01.1999 Gazette 1999/02)**

(54) **MAINS FILTER CIRCUIT ARRANGEMENT**

NETZFILTERANORDNUNG

DISPOSITIF DE CIRCUIT FILTRANT POUR LE SECTEUR

(84) Designated Contracting States:
**AT BE CH CY DE DK ES FI FR GB GR IE IT LI LU
MC NL PT SE**

(30) Priority: **30.06.1997 GB 9713878**

(43) Date of publication of application:
**26.04.2000 Bulletin 2000/17**

(73) Proprietor: **Roxburgh Electronics Limited
Newmarket, Suffolk CB8 7AA (GB)**

(72) Inventor: **TUCKER, Andrew, Cecil
Eaglehawk, VIC 3556 (AU)**

(74) Representative: **Ablett, Graham Keith et al
Ablett & Stebbing, Caparo House, 101-103 Baker
Street
London W1M 1FD (GB)**

(56) References cited:
**EP-A- 0 744 816        WO-A-94/05067
US-A- 5 327 027        US-A- 5 614 770**

**Description**

This invention relates to a mains filter circuit arrangement which employs active amplifying devices and is intended to improve the electromagnetic compatibility (EMC) of mains-fed systems by reducing the radio frequency interference (RFI) that is passed from mains-fed equipment into the mains network which feeds it. In EMC terms, this interference (also sometimes referred to as noise) is described as the "conducted emissions" for which the filter is attached to provide an "insertion loss".

The filter has special, though not exclusive, application to inverter and power supply type equipment and, in general, can be applied to reduce the mainsborne RFI generated by any equipment employing switched transistor control techniques.

With the introduction of new legislation, there is an increasing need for mains filtering.

Known mains filtering circuits use components in the form of passive series and shunt elements that produce attenuation of the problem noise largely by reflecting that noise. That is to say, arrangements of shunt capacitance and sometimes resistive elements and line inductance elements are used. For example, US-A-4 622 526 discloses a power line interference filter.

A problem with known mains filtering circuits is that the amount of attenuation obtained and the position of the cut off frequency is directly related to the magnitude of the parameters of the components used. As a result, in order to obtain more attenuation or a lower cut-off frequency, that is to say to improve the filtering performance, components with parameters having a larger magnitude must be used.

Unfortunately, to obtain larger magnitude parameters, it is necessary to use ever more bulky components as well as adding to the actual number of components used. This results in the drawbacks of:-

increased cost associated with the circuit components;
increased costs of assembly and manufacture;
increased heat loss; and
increased leakage current problems.

In addition, the use of more bulky components runs contrary to the generally accepted trend of making electrical apparatus smaller.

Another problem with known mains filtering circuits arises from the fact that the bulk of the passive components is directly related to the amplitude of the power frequency parameters, i.e. voltage and current. As a result, to cope with increased power voltage and current, it is necessary to increase the bulk of the components still further thereby intensifying the drawbacks mentioned above. For example, although the radio frequency noise power to be attenuated is typically of the order of 1 to 10 W, the power frequency level is of the order of 100 to 100,000 W and the bulk of the filter arises from the power frequency power levels.

Thus, at present, mains filtering circuits are designed and made according to the above described techniques accepting the drawbacks mentioned.

It is therefore an object of the present invention to provide a filtering circuit arrangement, utilising active components, which aims to provide insertion loss performance as good as or better than that of existing systems without the above mentioned drawback, and in particular, without increasing the bulk of the components used in the circuit compared with known mains filtering circuits.

Techniques involving the utilisation of active components such as transconductance amplifiers have been proposed in the general context of electromagnetic compatibility, one such proposal being disclosed in WO94/05067. However, the proposal therein relates not to the reduction of radio frequency conducted emissions, but rather to the reduction of harmonic currents resulting from the application of non-linear loads, by injection of antiphased compesating currents.

According to the present invention there is provided a radio frequency filter circuit for connection between a mains supply network and mains-operated equipment to reduce conduction of common mode emission noise from the equipment into the mains network, characterised by the provision of:

unity gain amplifying means (13) having its output connected to a power line of said mains suppy network;
earth reference circuit means (14) referencing to earth, over a predetermined frequency band, the input of said unity gain amplifying means;
current shunt circuit means (16) providing a path to earth for common mode current and
voltage dropping series impedance circuit means (12) connected between the equipment and said power line and configured to drop substantially all voltage associated with said emission noise,

the operation of the filter circuit being such as to cause the power line to substantially follow earth potential over said predetermined bandwidth at its point of connection with said unity gain amplifying means, thereby causing the noise level applied to the mains supply network over said predetermined frequency band to approach earth potential.

By using such a filter circuit, it is possible to obtain improved filtering performance without undue increase in components costs or component size and hence circuit size. Moreover, active units, such as the unity gain amplifying means, can be miniaturised onto circuit boards thereby further reducing the size of the mains filtering circuit.

It is preferred that the circuit comprises an AC power filtering circuit.

Examples of the present invention will now be described with reference to the accompanying drawings, in which:-

Figure 1 illustrates in schematic form a simple circuit showing the principle of operation of an example of the present invention for the differential mode;
Figure 2 illustrates in schematic form a simple circuit showing the principles of operation of an example of the present invention for the common mode;
Figure 3 shows in block diagrammatic form a filter circuit arrangement in accordance with one embodiment of the invention;
Figure 4 shows in greater detail the filter circuit arrangement of Figure 3;
Figure 5 shows an explanatory equivalent circuit;
Figure 6 shows a simplified version of the equivalent circuit of Figure 5;
Figure 7 is an equivalent circuit diagram presented in a form usefully indicative of loop stability;
Figures 8 and 9 illustrate modular implementations of the invention;
Figure 10 shows, in schematic outline and not to scale, the common mode noise spectral and time-domain characteristics before and after the noise conditioning network;
Figure 11 shows, in block diagrammatic form, another embodiment of the invention;
Figure 12 illustrates in greater detail the arrangement of Figure 11;
Figure 13 shows an equivalent circuit for the embodiment of the invention shown in Figures 11 and 12; and
Figure 14 is an equivalent circuit layout indicative of loop stability in the embodiment of Figures 11 and 12.

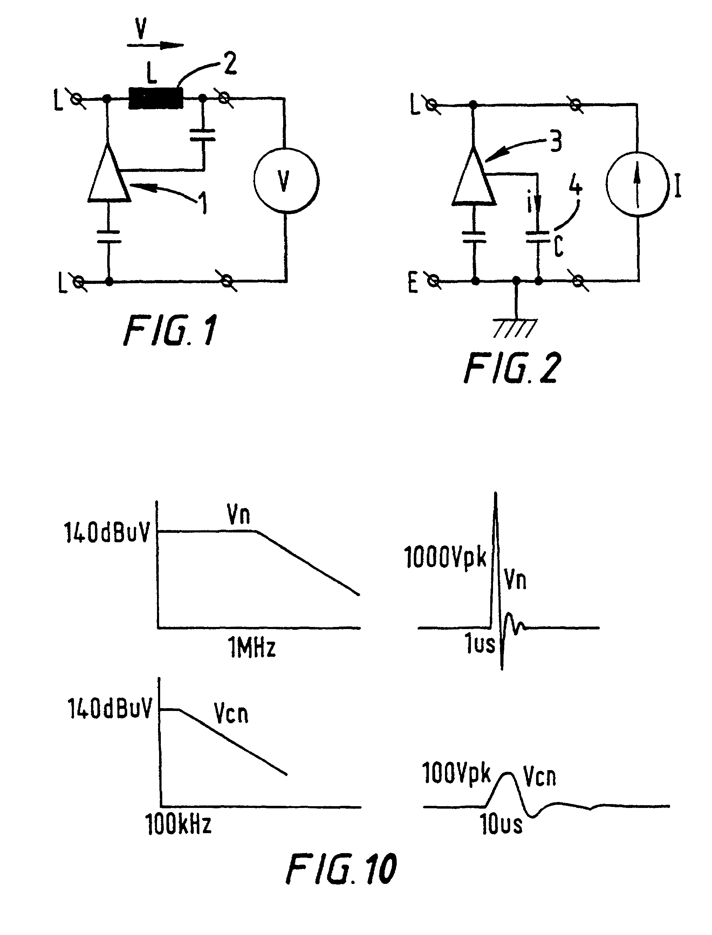

Referring now to figure 1, a voltage follower 1 applies voltage to a choke 2. As a result of the choke, a reacting voltage v is produced which will almost equal the noise voltage.

In figure 2, a voltage follower 3 is connected to apply a voltage across a capacitor 4. As a result of the capacitor, a reacting current i is produced which will almost equal the noise current.

Therefore, by incorporating the circuits shown in figures 1 and 2 into a mains filtering circuit, it is possible to reduce the number of components and the magnitude of their parameters compared with the prior art mains filtering circuits.

It will be understood that considerable benefits over conventional passive filtering are apparent, in particular on those high power systems where a significant insertion loss is desired, and that, in practice, the invention may be applied to many different configurations, some detailed embodiments of which will now be described, by way of example only.

The size of a conventional mains filter is determined primarily by the size of the passive power components (mains inductors and mains capacitors) which it employs. The factors influencing the component size can be shown by the relationship:

$$\text{Passive component size} = \frac{\text{Voltage} \times \text{Current} \times \text{Attenuation} \times \text{Temperature}}{\text{Frequency}}$$

Importantly, since the denominator in the above expression is frequency, it is the attenuation required at the lowest frequency that leads to the largest components. The expression also shows that the component size is further compounded by the magnitude of the mains voltage and current and the ambient temperature.

For an industrial mains filter, the above conditions are often extreme (over 60dB attenuation at 150kHz, 460Vac at more than 16A, with a working ambient temperature of $50°C$). This leads to passive filter components that can become both expensive and bulky. In order to achieve a large common mode attenuation at a reasonable price, the designer is forced to use large capacitors (Y class) connected to ground which produces an undesirably high earth leakage current. When mounting and enclosing these bulky components the size and cost of the filter is further compounded. Large inductors lead to significant temperature rise and associated heat loss, especially in larger filters.

The active filter used in accordance with the invention employs gain to increase the apparent size of the passive power components in particular at the low end of the required frequency bandwidth. This means that the same attenuation can be achieved with passive components at a fraction of the conventional size, especially in applications of high voltage, current and temperature. As a further consequence, a favourable earth leakage current can be achieved while still delivering a high attenuation. The overall power loss of this active circuit is less than an equivalent conventional filter.

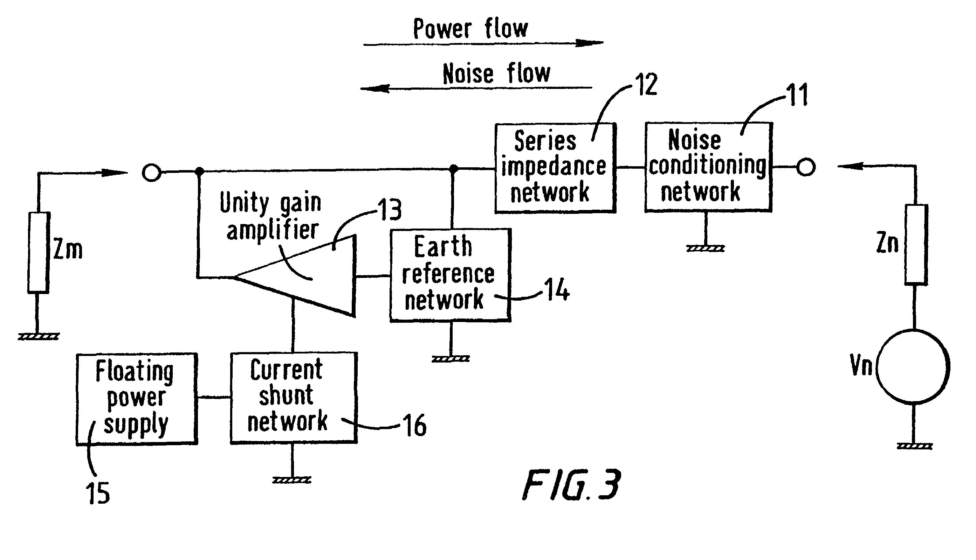

The block diagram shown in Figure 3 is orientated such that power flows left to right, while the emitted noise flows right to left.

Vn and Zn represent the Thevenin equivalent circuit for the noise emission source, while Zm represents the equivalent mains impedance to earth. The emitted noise is first conditioned by a small passive resonant filter 11, the so-called noise conditioning network, to adapt the noise to render it compatible to the active stage. The conditioned noise voltage is then dropped almost entirely across a small series impedance 12, the so-called series impedance network. The current required to produce this voltage drop is provided at the output of a high beta gain voltage follower 13, comprising a unity gain amplifier, whose input is referenced to earth potential, over a limited frequency band, by means of an earth reference network 14. A floating power supply 15 supplies the amplifier in the voltage follower circuit 13 and behaves like a current source relative to earth. The current is driven from here through a current shunt network 16 back to the noise source via earth.

In this way the power line is forced to follow the earth potential over a limited bandwidth at the point of connection of the unity gain amplifier output. The noise level on the mains over this bandwidth will therefore be much closer to earth potential.

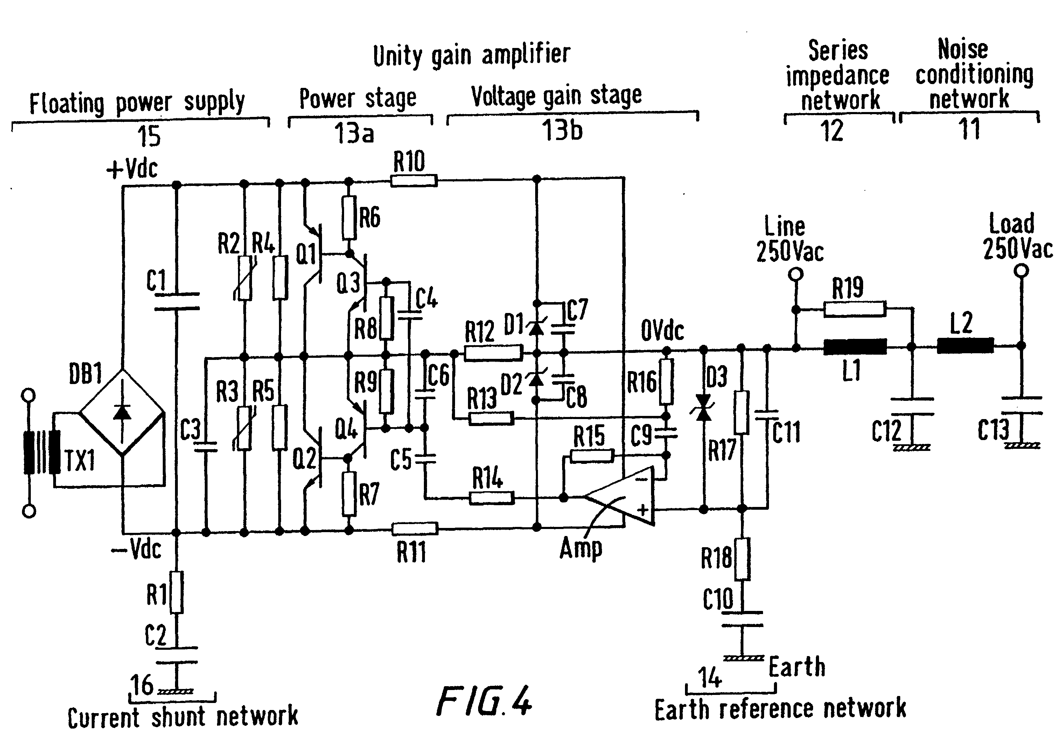

Figure 4 shows the circuitry required for each phase of the mains system and supports the following detailed description of its function.

The floating power supply 15 is constituted in this example by a linear power supply, chosen for its low noise and low cost, being less than 10W. It incorporates a single phase power transformer TX1, with functional isolation between primary and secondary, which provides voltage transformation and a floating secondary. A bridge rectifier DB1 provides a dc voltage which is smoothed by capacitor C1. A resistor divider R4 and R5 provides a loose dc symmetry about the emitter connections of an amplifier power stage 13a of the aforementioned unity gain amplifier. The primary side of the transformer is fed either between lines or between line and neutral. The pre-amplifier is trickle fed via resistors R10 and R11, the voltage established by zener diodes D1 and D2. This supply is firmly clamped to the 0V rail and smoothed by capacitors C7 and C8. A suitable voltage amplifier is chosen to provide any further rejection of ripple voltage on the supply rails.

The amplifier 13 is actually a transconductance amplifier as there is a fixed relationship between the output current Ip and the input voltage V+. It will be referred to here as a unity gain amplifier, however, as it provides principally a voltage following function. Its power stage 13a includes a complementary Darlington (Sziklai connected) push-pull transistor array Q1, Q2, Q3 and Q4 which provides a high beta gain emitter follower circuit. Transistors are biased 'off' (C class) with resistors R6, R7, R8 and R9. Bipolar junction transistor devices are shown. However, where larger voltage swings are required (>100V), FET power devices can be used. Transistors can be biased 'on' (class B) which can improve the filter performance. However this also adds complexity to the circuit and is therefore not preferred.

Its voltage gain stage 13b includes capacitor C9 and resistor R15, which are chosen to provide a low frequency pole such that the differential amplifier output is biased to 0V. The output of the differential amplifier is capacitor coupled to the two base terminals of the power stage, driving through C4 and C5. The emitter current is converted to a voltage across emitter resistor R12. The resistance of resistor R12 is transformed to a much larger resistance via the emitter follower to provide a significant load resistance for the pre-amplifier output. Feedback resistor divider R13 and R16 provides a voltage at the negative input of the differential amplifier which is a fraction of the emitter voltage. With sufficient gain and bandwidth, the positive and negative inputs to the differential amplifier are caused to follow one another. The voltage drop across R17 is then a scalar function of the emitter current. An approximate voltage follower is therefore formed between the positive input of the differential amplifier and the 0V rail; the small error voltage being that across R17.

The voltage amplification has been shown here for simplicity as being provided by a differential amplifier. Typical circuit parameters require a closed loop gain of 40dB between 50kHz and 500kHz. To achieve this the amplifier requires an open loop gain of at least 60dB up to a frequency of 500kHz. This would in principle lead to a requirement for a device with a gain bandwidth product of 500MHz. However a better solution to this in practice achieves the gain with discrete components (2 or 3 wide band transistors).

The earth reference network 14 comprises a 2 pole RC network C10, C11, R17 and R18, and provides a band pass input to the positive terminal of the differential amplifier. In the mid-band, the positive input is referenced to earth with zero phase shift. Mains isolation is provided by C10 which is an approved Y class capacitor. The network poles are placed suitably to eliminate the mains waveform and any associated corruption from the amplifier circuit.

The current shunt network 16 incorporates a 2 pole RC network C2, C3, R1, R4 and R5, and provides a path for the current sourced from the (effective) collectors of the power stage. This is the same current that is drawn through the emitter resistor R12. The resultant voltage developed across the shunt network has no influence over circuit stability. The network poles are placed suitably to eliminate the mains waveform and any associated corruption from the amplifier circuit. Mains isolation is provided by C2 which is an approved Y class capacitor.

The series impedance network 12 consists of an inductor L1 with parallel resistor R19 and provides (in-band) a largely flat resistive impedance to the noise voltage while passing the system power current.

In the noise conditioning network 11, a conventional LC low pass filter is represented by C12, C13 and L2. These components are selected to resonate within the active filter pass band to modify the noise waveform in the following ways:

(a) peak noise voltage is reduced to a level that will be compatible with the active circuit;
(b) the noise energy is concentrated within the pass band of the active circuit, i.e., a resonant 'ring' wave is produced whose frequency is placed where the active circuit can deal with it; and
(c) higher frequencies, too fast for the active filter, will be removed by this filter in the conventional way.

The filter actually consists of a common mode choke with X and Y capacitors similar to conventional single phase and multi phase filters.

In terms of circuit protection, the influence of potentially destructive or disturbing mainsborne noises on the active circuit is limited by the use of the band pass RC networks on both the current shunt network 16 and the earth reference network 14. In addition to this, the positive input to the differential amplifier is clamped in both polarities by Transorb diode D3 and the dc voltage rails are clamped using VDR devices R2 and R3.

Thus the invention provides, by these means, an active circuit capable of reducing continuous emitted noise signals on an ac mains system.

The use of a unity gain (transconductance) amplifier with floating power supply, such that the supply performs like a voltage controlled current source relative to earth, is regarded as an important feature, as is the use of a small conventional mains filter to modify the noise into a lower frequency ring wave, such that an active filter circuit with modest bandwidth can then be applied.

The following parameters are given as a practical guide to typical circuit and component requirements. These have been developed from noise levels and circuit impedances experienced in practice.

Floating power supply 15:

Input 415/250Vac
Output 5W continuous, floating, 100Vdc.

Unity gain amplifier 13:

Low end break point 50kHz
High end break point 500kHz
Transconductance (gain) 40dB mid-band (Ip/V+)
Effective output resistance Ro = 0.01 ohm
Output current +/-10Apk
Output voltage +/-50Vpk
Continuous power 5W
Instantaneous power 500W

Noise conditioning network 11:

Low pass break point (resonance) 180kHz
60dB roll-off
Zo 23R

Series impedance network 12:

L = 10uH
R = 10R

Earth reference network 14:

C10 = 1nF
C11 = 1nF
R17 = 3.3k
R18 = 330R

Mains rejection 60dB

Current shunt network 16:

C2 = 100nF

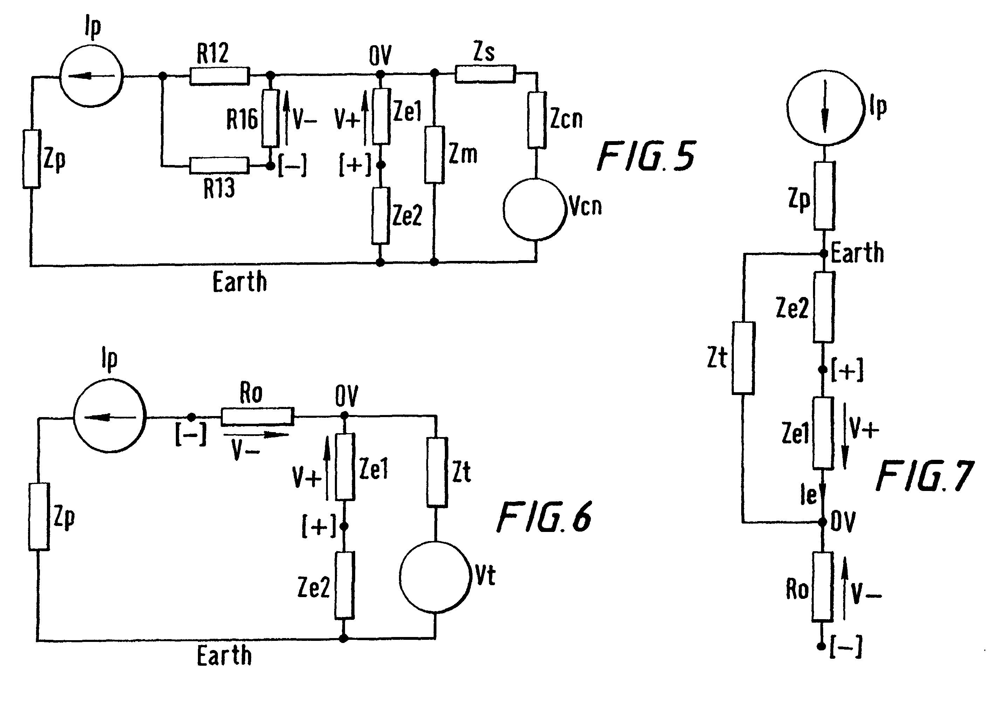

An equivalent circuit for the embodiment of the invention described above with reference to figures 3 and 4, in which the active filter circuit, together with peripheral terminations, is shown in Figure 5. Where the following description of this equivalent circuit refers to elements in both Figures 4 and 5, the same reference numbers or references are used.

Vcn and Zcn form the Thevenin equivalent circuit at the noise output of the noise conditioning network 11, where Vcn is the open circuit voltage and Zcn is the equivalent impedance for C12, C13, L2 and Zn.

Zs (L1 and R19) is the impedance of the series impedance network 12.

Zm is the mains impedance relative to earth, which may differ substantially from that of the mains network defined in the international specification CISPR16 (50R, 50uH, 5R).

Ze1 (C11 and R17) and Ze2 (C10 and R18) form the earth reference network 14.

Ip is the current source (relative to earth) formed at the power supply rails of the unity gain amplifier 13.

The voltage amplifier in effect forces V- to follow V+ so that Ip can be defined in terms of V+ as follows:

$$Ip = \frac{(R13 + R16) * V+}{R16 * R12}$$

Zp (C2 and R1) is the impedance of the current shunt network 16.

The equivalent circuit is further simplified in Figure 6.

Here, Vt and Zt form the Thevenin equivalent circuit at the output of the unity gain amplifier (0V), where Vt is the open circuit noise voltage, relative to earth, that remains after conditioning and Zt is the equivalent impedance for Zcn, Zs and Zm.

$$Zt = \frac{Zm * (Zs + Zm)}{Zm + Zs + Zcn}$$

Ro is the effective output impedance of the unity gain amplifier. The output impedance is actually R12 which is reduced, via negative feedback, by a ratio equivalent to the voltage gain (R13+R16)/R16. Ro is therefore defined as:

$$Ro = \frac{R16 * R12}{R13 + R16}$$

Ip can now be defined simply as:

$$Ip = V+/Ro$$

The transconductance (gain) is Ip/V+ = 1/Ro.

Insertion Loss is defined as IL (dB) = 20 LOG $V_1/V_2$, where $V_1$ is the noise voltage before filter insertion and $V_2$ is the noise voltage after filter insertion.

Vt is, in effect, the noise voltage that would appear on the mains impedance (Zm) after the noise conditioning network 11 (Zcn) and the series impedance network 12 (Zs) without any active circuit present (i.e. with the active element switched 'off').

V+ is, in effect, the residual voltage left on the mains with the active circuit present. (i.e. with the active element switched 'on').

Thus, for simplicity, the insertion loss of the active element alone can be defined as:

$$IL\text{-active (dB)} = 20 \text{ LOG } Vt/V+$$

For the in-band frequency range, Ze1 >> Ze2, so V+ will be virtually at earth potential. As a voltage Vt starts to appear, it induces a small voltage at V+ which, in turn, induces a current Ip = V+/Ro. This current flows back though Zp and the equipment earth. The current flows through Zt and induces a reactive voltage

$$Vr = IpZt \text{ such that } Vr = -Vt \text{ approximately.}$$

Therefore

$$Vt/V+ = Zt/Ro$$

If Zt is around 10R at 150kHz and if R12=1R, R13=10k and R16=100R, then:

$$Ro = 0.01R$$

$$IL\text{-active} = 20 \text{ LOG } 10/0.01 = 60dB$$

The current Ip that is shunted back via earth induces a voltage at the positive input of the differential amplifier. Suitable compensation must be provided to avoid instability. Figure 7 shows this current loop in an open format.

If a voltage is induced at V- a current Ip = V-/Ro is produced; V- and Ip being in phase. If Zt, Ze1 and Ze2 were all real impedances then the resultant voltage at V+ would be negative relative to V- (180 degrees out of phase). In this condition the feedback is negative and the circuit is stable.

The circuit will remain stable provided the loop phase angle between phasors V+ and V- is never zero while the loop gain in greater than unity.

The relationship between V+ and V- is given by:

$$V+ = \frac{Ze1 * Zt * V-}{(Zt + Ze1 + Ze2) * Ro}$$

Within the frequency band 50kHz to 500kHz,

$$Ze1 >> Zt \text{ and } Ze2$$

so this expression simplifies to:

$$V+ = \frac{Zt * V-}{Ro} \qquad \text{where } Zt = \frac{Zm * (Zs + Zm)}{Zm + Zs + Zcn}.$$

Since V- and Ro are in phase, the loop phase angle is determined entirely by that of Zt. Therefore the phase of Zt can vary by 180 degrees in either direction before instability can occur. The loop gain is Zt/Ro = 1000 (for the given parameters).

In the low band (below 50kHz):

Ze2 >> Zt and Ze1
Zt is dominated by Zm

So the equation becomes

$$V+ = \frac{Ze1 * Zm * V-}{Ze2 * Ro}$$

In order to reject the low frequency mains signals Ze1 (resistive R17) and Ze2 (capacitive C10) are chosen to form a pole at 50kHz. This gives a mains fundamental (50Hz) rejection of 60dB (250Vac mains sees only 0.25Vac at R17 relative to 0V). This induces a 90 degree phase lead.

The amplifier transconductance 1/Ro should be reduced gradually with diminishing frequency by a chain of pole-zero compensatory elements. These have not been shown in the drawing, but would induce a maximum phase lead of 45 degrees.

At lower frequencies, Zm is difficult to predict. If it is inductive, however, stability problems can arise.

The accumulated phase shift is then:

Ze1        0 degrees.
1/Ze2        leading 90 degrees.
1/Ro        leading 45 degrees
Zm        assume 0 degrees

This leaves a phase margin of 45 degrees.

Above 500kHz, in the high band:

Ze2 » Zt and Ze1
Zt is dominated by Zs

So the equation becomes

$$V+ = \frac{Ze1 * Zs * V-}{Ze2 * Ro}$$

In order to reject the high frequency mains borne signals Ze1 (capacitive C11) and Ze2 (resistive R18) are chosen to form a pole at 500MHz. This induces a 90 degree phase lag.

The amplifier transconductance 1/Ro should be reduced gradually with increased frequency by a chain of pole-zero compensatory elements. These have not been shown in the drawings. This would induce a maximum phase lag of 45 degrees

Zs is real, so induces zero phase shift.
The accumulated phase shift is then:

Ze1      lagging 90 degrees
1/Ze2      0 degrees
1/Ro      lagging 45 degrees
Zs      0 degrees

This leaves a phase margin of 45 degrees.

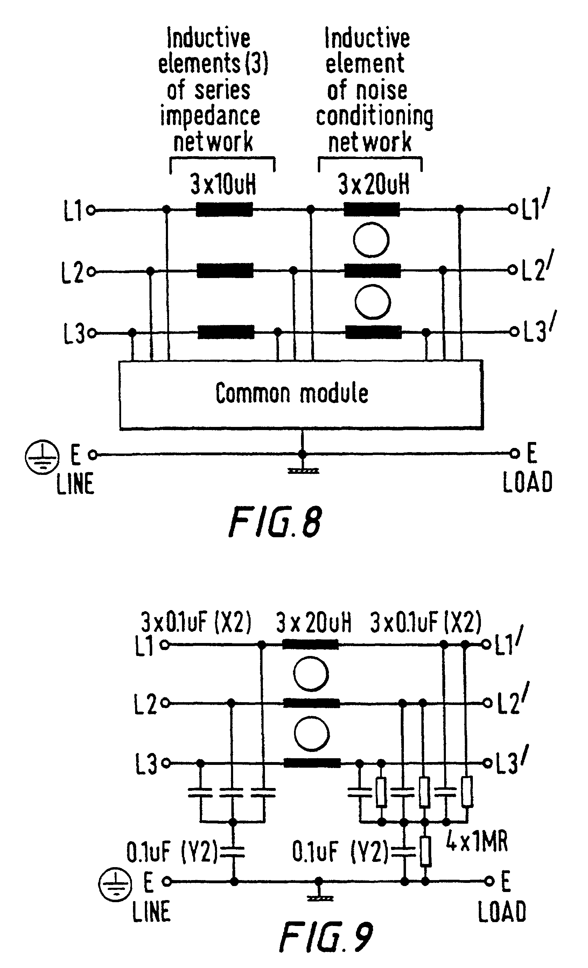

In practical constructions of the arrangement, all but the inductive elements of the active filter preferably reside on a common printed circuit board (PCB) module as shown in Figure 8. This module is common to the whole filter family, and may, instead of being fabricated in PCB form, be based on a different fabrication procedure, such as thick film hybrid technology.

The inductive elements referred to above are the those of the series impedance network 12 and the noise conditioning network 11. Figure 8 depicts a 3 phase, 3 wire filter system with 4 inductive elements. This configuration can equally be applied to 2 wire and 4 wire mains systems with 3 and 5 inductive elements respectively. It is necessary to have the inductive elements separate from the PCB as their bulk is dependent on the current rating of the filter. This is necessary to achieve a consistent temperature rise on the inductor windings.

The common module consists of a separate active circuit for each phase in the applied mains system. A single transformer with multiple secondaries can be used, one for each phase. One heat sink (10W approx.) is provided for all the power transistors (Q1 and Q2).

It is possible to use the common module because none of the components, except the inductors, need to change with differing filter current rating, and because the attenuation desired of the active filter does not affect the output parameters required (power, voltage and current swing). This can be further demonstrated as follows:

The noise parameters produced for systems employing pulse width modulation (PWM) switch transistor control techniques are relatively constant irrespective of current drawn, therefore the insertion loss requirements remain the same.

The active circuit power stage will be the same irrespective of attenuation prescribed for the filter. This can be seen if it is noted that a 40dB filter would remove 99.00% of the noise energy and an 80dB filter 99.99%. Clearly even though the filters differ in attenuation by 40dB, both filters deal with almost the same level of noise.
Mains Y capacitor ratings remain the same, as the system mains voltage is specified and fixed for the filter family.

With regard specifically to the detail of the noise conditioning network 11, Figure 9 shows the circuit, which is essentially a small conventional mains filter. The circuit is required to condition the common mode noise only as the differential mode (DM) noise is already compatible with the active circuit. The common mode inductance and equivalent Y capacitance are chosen to give a resonance within the frequency range of the active circuit (in the figure shown at around 180kHz). The resonant impedance is around 23 ohms which into the series impedance network of 10 ohms (resistive) will be favourably overdamped. Note that this filter alone would provide no attenuation at 150kHz. The X capacitors are provided as a coupling path for the Y capacitors only. The X capacitors will resonate at a much higher frequency (in the figure shown at around 1.6MHz). The level of DM noise level is extremely low at this frequency and causes no problem. Also the DM resonant impedance is around 2 ohms which is damped out through the losses at 1.6MHz.

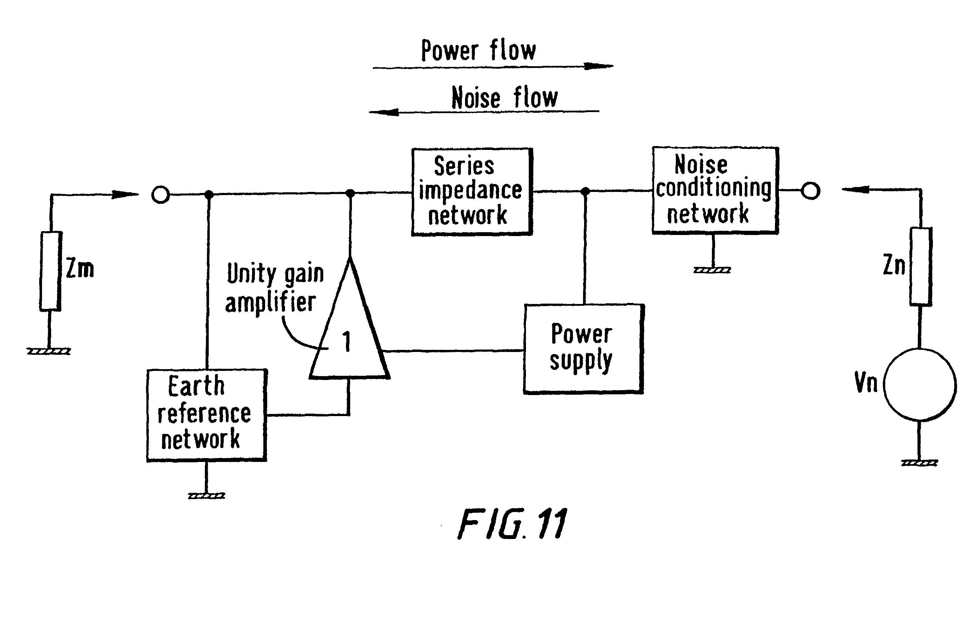

Figure 10 indicates (not to scale) the common mode noise spectral and time domain characteristics before and after the noise conditioning network. Vcn has the high frequencies of Vn removed and, as a result, the peak voltage is reduced and the ring period increased. A filter break point at around 100kHz brings about a 10 fold reduction in peak voltage, slew rate and noise power.

It is advantageous to keep the earth leakage current ($I_L$) produced by a mains filter to a minimum. Traditionally, to achieve a large insertion loss for a high power filter (in a cost-effective manner), it is necessary to have a high leakage current (>100mA). The active filter of this embodiment of the invention provides an acceptably low leakage.

Given the foregoing parameters and assuming a 3 phase mains system of 400V at 50Hz, the earth leakage current $I_L$ caused to flow during a single fault condition (equivalent to the method specified by the international IEC950 specification) will be as follows:

Each 0.1uF star network in the noise conditioning network produces 2.4mA leakage while the 0.1uF capacitor in each current shunt network gives 7.2mA leakage. (Ignoring the 1nF of the earth reference network).

Thus for the circuit of Figures 3 and 4,

$$I_L = 2.4 + 2.4 + 7.2 = 12\text{mA}.$$

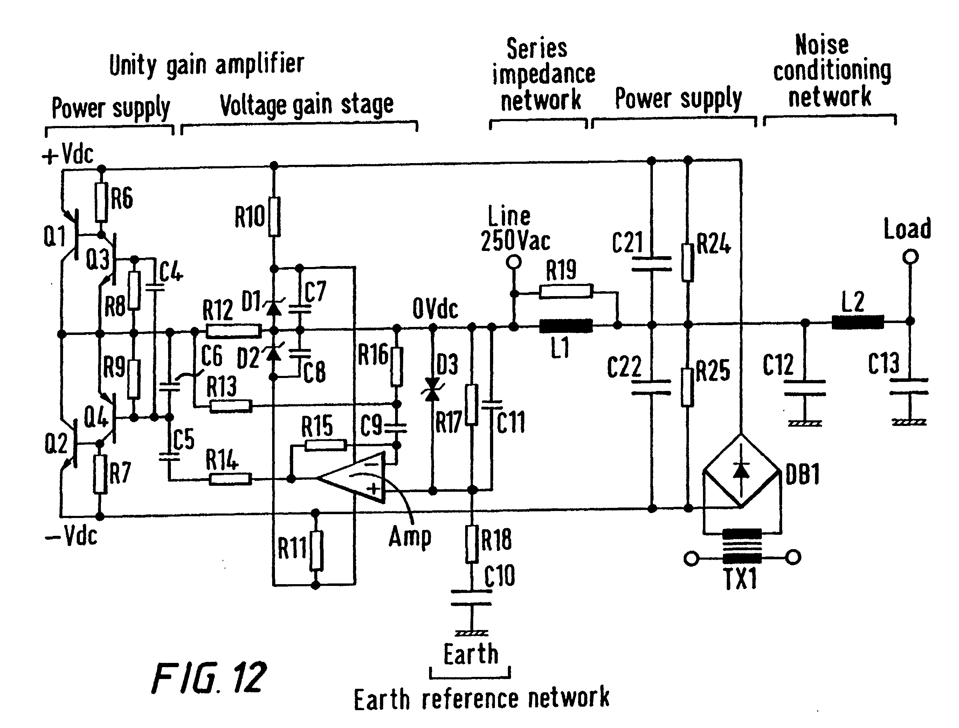

For the circuit to be described below, with respect to Figures 11 and 12,

$$I_L = 2.4 + 2.4 = 4.8\text{mA}.$$

This level of leakage is suitable to operate together with a 30mA earth leakage detector. The earth leakage current under normal running conditions will be less than 1/5th of the above figures in each case.

Figures 11 and 12 show an embodiment of the invention utilising an alternative circuit architecture to that shown in Figures 3 and 4.

Most of the alternative circuitry can be exactly the same as that described above. The principal change involves the current path Ip. The current shunt network is removed and the power supply is no longer floating. Instead, the power supply is referenced to the line between the series impedance network and the noise conditioning network. Therefore the current Ip flows, not via earth as before, but directly to the 'noisy' side of the series impedance network.

Figure 12 shows the changes to the detailed circuit diagram. The output of the bridge rectifier is smoothed and firmly clamped to the line by two reservoir capacitors C21 and C22. Bleed resistors R24 and R25 ensure dc symmetry. The dynamic requirements of voltage and current are unchanged and indeed the function of the circuit has not changed, therefore other circuit elements and their operation remain the same.

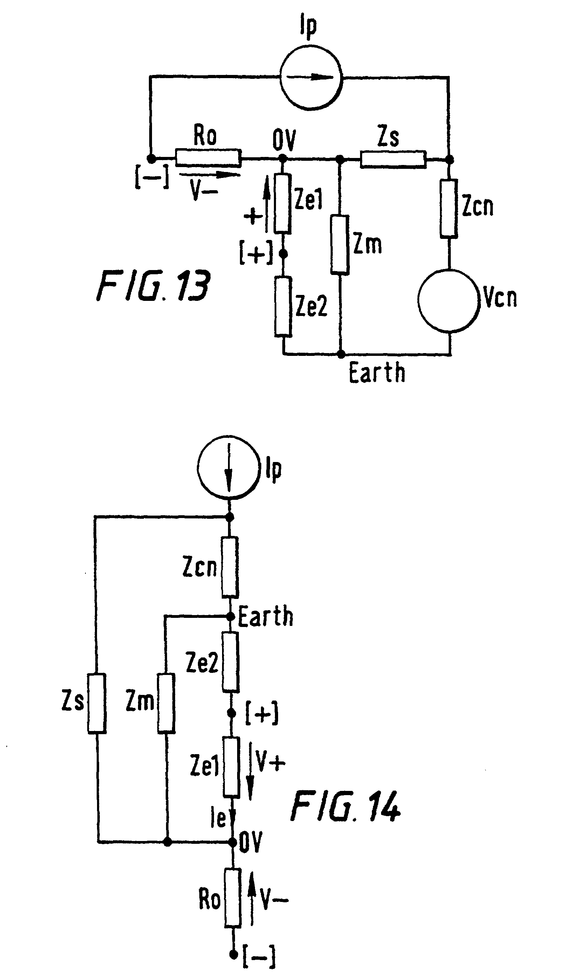

Figure 13 shows the revised equivalent circuit, emphasizing the alterations to the return current path.

The return current Ip is related to V+ as before:

$$Ip = V+/Ro$$

The current is now injected directly onto the series impedance network (Zs). The mains impedance Zm is now on a side limb in series with Zcn so has less influence over the stability of the circuit.

The insertion loss achieved is the same as before if the same circuit parameters are used.

Figure 14 is provided for comparison with Figure 7.

The choice between the two principal embodiments of the invention disclosed herein will usually be determined by operational parameters and/or circuit architecture. The embodiment of Figures 3 and 4 can inherently deal equally with noise from either the line side or the load side. However it has an extra path to earth (the current shunt network) which can, in some circumstances, make stability harder to achieve. Also, in the low band, the mains impedance Zm becomes very dominant.

With regard to the arrangement of Figures 11 and 12, the dominant impedance in the current path can be made to be Zs, which gives more control over stability. This circuit, however, may exhibit greater sensitivity to incoming noise (from the line side) which, if unchecked, can cause the amplifier to saturate.

**Claims**

1.  A radio frequency filter circuit for connection between a mains supply network and mains-operated equipment to reduce conduction of common mode emission noise from the equipment into the mains network, **characterised by** the provision of:

    unity gain amplifying means (13) having its output connected to a power line of said mains suppy network;
    earth reference circuit means (14) referencing to earth, over a predetermined frequency band, the input of said unity gain amplifying means;
    current shunt circuit means (16) providing a path to earth for common mode current and voltage dropping series impedance circuit means (12) connected between the equipment and said power line and configured to drop substantially all voltage associated with said emission noise,

    the operation of the filter circuit being such as to cause the power line to substantially follow earth potential over said predetermined bandwidth at its point of connection with said unity gain amplifying means, thereby causing the noise level applied to the mains supply network over said predetermined frequency band to approach earth potential.

2.  A filter circuit according to claim 1 **characterised by** the provision of a floating power supply for said unity gain amplifying means; said current shunt network (16) being connected between said power supply and said unity gain amplifying means.

3.  A filter circuit according to claim 1 **characterised by** the provision of a passive conditioning network (11) configured and connected to render said noise compatible with the unity gain amplifying circuit.

4.  A filter circuit according to claim 3 **characterised by** the provision of a power supply (Fig. 11; DB1, C21, C22, R24 and R25, Fig. 12), for said unity gain amplifying means (13), referenced to the junction of said passive conditioning network (11) and said impedance network.

5.  A filter circuit according to any preceding claim comprising a printed circuit module incorporating all non-inductive components thereof.

6. A filter circuit according to any preceding claim **characterised in that** the unity gain amplifying means (13) is caused to exhibit low and high frequency break points at 50kHz and 500kHz respectively.

**Patentansprüche**

1. Radiofrequenz-Filterschaltung zum Anschluß zwischen einem Stromversorgungsnetz und einem netzgespeisten Gerät zum Reduzieren einer Leitung eines Gleichtakt-Emissionsrauschens vom Gerät in das Versorgungsnetz, **gekennzeichnet durch** das Vorsehen

einer Verstärkungseinrichtung mit der Verstärkung Eins (13), die ihren Ausgang mit einer Leistungsleitung des Stromversorgungsnetzes verbunden hat;
einer Erdungsreferenz-Schaltungseinrichtung (14), die den Eingang der Verstärkungseinrichtung mit der Verstärkung Eins über einem vorbestimmten Frequenzband auf Erde bezieht;
einer Stromnebenschluß-Schaltungseinrichtung (16), die für einen Gleichtaktstrom einen Pfad zur Erde zur Verfügung stellt; und
einer Spannungsabfall-Reihenimpedanzschaltungseinrichtung (12), die zwischen dem Gerät und der Leistungsleitung angeschlossen ist und konfiguriert ist, um im wesentlichen die gesamte Spannung abfallen zu lassen, die zum Emissionsrauschen gehört,
wobei der Betrieb der Filterschaltung derart ist, daß veranlaßt wird, daß die Leistungsleitung an ihrer Anschlußstelle zur Verstärkungseinrichtung mit der Verstärkung Eins über der vorbestimmten Bandbreite im wesentlichen einem Erdungspotential folgt, um **dadurch** zu veranlassen, daß sich der an das Stromversorgungsnetz angelegte Rauschpegel über dem vorbestimmten Frequenzband dem Erdungspotential nähert.

2. Filterschaltung nach Anspruch 1, **gekennzeichnet durch** das Vorsehen einer schwebenden Leistungsversorgung für die Verstärkungseinrichtung mit der Verstärkung Eins, wobei das Stromnebenschlußnetz (16) zwischen der Leistungsversorgung und der Verstärkungseinrichtung mit der Verstärkung Eins angeschlossen ist.

3. Filterschaltung nach Anspruch 1, **gekennzeichnet durch** das Vorsehen eines passiven Aufbereitungsnetzes (11), das konfiguriert und angeschlossen ist, um das Rauschen kompatibel zur Verstärkungseinrichtung mit der Verstärkung Eins zu machen.

4. Filterschaltung nach Anspruch 3, **gekennzeichnet durch** das Vorsehen einer Leistungsversorgung (Fig. 11; DB1, C21, C22, R24 und R25, Fig. 12) für die Verstärkungseinrichtung mit der Verstärkung Eins (13), die auf die Verbindungsstelle des passiven Aufbereitungsnetzes (11) und des Impedanznetzes bezogen ist.

5. Filterschaltung nach einem der vorangehenden Ansprüche, die ein Leiterplattenmodul aufweist, das alle ihre nichtinduktiven Komponenten bzw. Bauteile enthält.

6. Filterschaltung nach einem der vorangehenden Ansprüche, **dadurch gekennzeichnet, daß** die Verstärkungseinrichtung mit der Verstärkung Eins (13) veranlaßt wird, Nieder- und Hochfrequenz-Unterbrechungspunkte bei jeweils 50 kHz und 500 kHz zu zeigen.

**Revendications**

1. Circuit de filtrage radiofréquence destiné à être connecté entre un réseau d'alimentation secteur et un équipement alimenté sur secteur afin de réduire la conduction du bruit d'émission en mode commun provenant de l'équipement dans le réseau d'alimentation secteur, **caractérisé par** la prévision de :

- moyens d'amplification à gain unitaire (13) ayant leur sortie connectée à une ligne électrique dudit réseau d'alimentation secteur ;
- moyens formant circuit de référence à la terre (14) référençant à la terre, dans une bande de fréquences prédéterminée, l'entrée desdits moyens d'amplification à gain unitaire ;
- moyens formant circuit de dérivation de courant (16) fournissant un trajet à la terre pour le courant de mode commun ; et
- moyens formant circuit d'impédances série de chute de tension (12) connectés entre l'équipement et ladite ligne électrique et configurés de manière à faire chuter sensiblement toute la tension associée audit bruit d'émission ;

le fonctionnement du circuit de filtrage étant tel qu'il amène la ligne électrique à suivre sensiblement le potentiel de la terre dans ladite bande passante prédéterminée à son point de connexion avec lesdits moyens d'amplification à gain unitaire, amenant de ce fait le niveau de bruit appliqué au réseau d'alimentation secteur dans ladite bande de fréquences prédéterminée à approcher le potentiel de la terre.

**EP 0 995 266 B1**

**2.** Circuit de filtrage selon la revendication 1, **caractérisé par** la prévision d'une alimentation flottante pour lesdits moyens d'amplification à gain unitaire ; ledit réseau de dérivation de courant (16) étant connecté entre ladite alimentation et lesdits moyens d'amplification à gain unitaire.

**3.** Circuit de filtrage selon la revendication 1, **caractérisé par** la prévision d'un réseau de conditionnement passif (11) configuré et connecté de manière à rendre ledit bruit compatible avec le circuit d'amplification à gain unitaire.

**4.** Circuit de filtrage selon la revendication 3, **caractérisé par** la prévision d'une alimentation (Figure 11 ; DB1, C21, C22, R24 et R25, Figure 12), pour lesdits moyens d'amplification à gain unitaire (13), référencée à la jonction dudit réseau de conditionnement passif (11) et dudit réseau d'impédances.

**5.** Circuit de filtrage selon l'une quelconque des revendications précédentes, comprenant un module de circuit imprimé incorporant tous les composants inductifs de celui-ci.

**6.** Circuit de filtrage selon l'une quelconque des revendications précédentes, **caractérisé par le fait que** les moyens d'amplification à gain unitaire (13) sont amenés à présenter des points de coupure de haute et basse fréquence respectivement à 50 kHz et 500 kHz.

FIG.1

FIG.2

FIG.10

FIG.3

FIG.4

Floating power supply 15 · Unity gain amplifier (Power stage 13a · Voltage gain stage 13b) · Series impedance network 12 · Noise conditioning network 11 · Current shunt network 16 · Earth reference network 14

EP 0 995 266 B1

FIG.5

FIG.6

FIG.7

EP 0 995 266 B1

FIG.8

FIG.9

Power flow →

Noise flow ←

Series impedance network

Noise conditioning network

$Zm$

Unity gain amplifier

1

Power supply

Earth reference network

$Zn$

$Vn$

*FIG. 11*

EP 0 995 266 B1

*FIG. 12*

17

FIG.13

FIG. 14